# EUROPÄISCHE PATENTANMELDUNG

(11) **EP 1 816 746 A2**
(43) Veröffentlichungstag der Anmeldung: **08.08.2007**
(21) Anmeldenummer: 07001566.4
(22) Anmeldetag: 25.01.2007
(51) Int. Cl.: H03K 17/96

(54) **Berührungsempfindlicher Tastschalter**

(30) Priorität: 01.02.2006 DE 102006004979
(71) Anmelder: Diehl AKO Stiftung & Co. KG, 88239 Wangen (DE)
(72) Erfinder: Arnold, Georg, 91126 Schwabach (DE)
(74) Vertreter: Diehl Patentabteilung

(57) **Zusammenfassung**

Es wird ein berührungsempfindlicher Tastschalter (10) mit einem optischen Sensor (14, 16), insbesondere einem Infrarot-Sensor, und einer Auswerteschaltung (40) vorgeschlagen, wobei die Auswerteschaltung (40) mittels einer Referenzeinrichtung (32, 38) in der Lage ist, in Abhängigkeit von einem erfassten Grundpegel (V_{REF}) des Auswertesignals (V_{IN}) eine Empfindlichkeit des optischen Sensors einzustellen.

## Beschreibung

Die vorliegende Erfindung betrifft einen berührungsempfindlichen Tastschalter nach dem Oberbegriff des Anspruchs 1, und insbesondere einen solchen Tastschalter zur Verwendung in einer Bedienungseinrichtung eines Haushaltsgeräts.

Der grundsätzliche Aufbau und das Grundprinzip eines solchen berührungsempfindlichen Tastschalters sind zum Beispiel aus der DE 40 07 971 A1 bekannt. Der berührungsempfindliche Tastschalter weist einen elektromagnetische Strahlung aussendenden Sender und einen elektromagnetische Strahlung empfangenden Empfänger auf, die hinter einer für die elektromagnetische Strahlung zumindest teildurchlässigen Abdeckung angeordnet sind. Ferner ist im Allgemeinen eine Auswerteschaltung zum Auswerten eines von dem Empfänger erzeugten Messsignals und Erzeugen eines Auswertesignals zur weiteren Verarbeitung vorgesehen. Eine vorteilhafte Anwendung derartiger berührungsempfindlicher Tastschalter ist zum Beispiel der Einsatz in Bedienungseinrichtungen von Haushaltsgeräten, wie Kochherden, Glaskeramik-Kochfeldern, Mikrowellenherden und dergleichen, bei denen der Tastschalter zur einfachen Bedienung und Reinigung hinter einer Abdeckung, wie beispielsweise einer Glasplatte oder Glaskeramikplatte untergebracht ist.

Bei herkömmlichen Tastschaltern dieser Art besteht ein Problem, dass verschiedene Tastschalter eines Bedienfeldes im Allgemeinen aufgrund unterschiedlicher Umgebungseinflüsse und Toleranzfehler seiner Komponenten nicht immer gleich zueinander und auch nicht über einen längeren Zeitraum unverändert reagieren, was die Bedienung eines Bedienfeldes für einen Benutzer gegebenenfalls erschwert und die Lebensdauer des Bedienfeldes verringert.

Es ist daher eine Aufgabe der vorliegenden Erfindung, einen berührungsempfindlichen Tastschalter vorzusehen, bei dem die oben genannten Nachteile herkömmlicher Tastschalter vermieden werden und insbesondere eine wohldefinierte Bedienbarkeit auch über einen langen Zeitraum gewährleistet werden kann.

Gemäß der Erfindung wird diese Aufgabe durch einen berührungsempfindlichen Tastschalter mit den Merkmalen des Anspruchs 1 gelöst. Vorteilhafte Ausgestaltungen und Weiterbildungen dieses Tastschalters sind Gegenstand der Unteransprüche.

Der erfindungsgemäße berührungsempfindliche Tastschalter umfasst einen optischen Sensor, der einen elektromagnetische Strahlung aussendenden Sender und einen elektromagnetische Strahlung empfangenden Empfänger enthält und der hinter einer für die elektromagnetische Strahlung zumindest teildurchlässigen Abdeckung angeordnet ist; und eine Auswerteschaltung zum Auswerten eines von dem Empfänger des optischen Sensors erzeugten Messsignals und Erzeugen eines Auswertesignals. Der Tastschalter ist weiter dadurch gekennzeichnet, dass ferner eine Referenzeinrichtung zum Leiten eines Teils der von dem Sender ausgesendeten elektromagnetischen Strahlung auch ohne Betätigung des Tastschalters zum Empfänger und Erzeugen eines Grundpegel des Auswertesignals vorgesehen ist; und dass die Auswerteschaltung in Abhängigkeit von dem erfassten Grundpegel des Auswertesignals eine Empfindlichkeit des optischen Sensors einstellt.

Durch den obigen Aufbau des Tastschalters wird erreicht, dass der Empfänger auch ohne Betätigung des Tastschalters eine kleine Strahlungsmenge empfängt und so ein entsprechendes Messsignal erzeugt, aus dem ein Grundpegel des Auswertesignals bestimmt wird. In Abhängigkeit von dem so erfassten Grundpegel des Auswertesignals stellt die Auswerteschaltung dann jeweils eine Empfindlichkeit des optischen Sensors ein. Auf diese Weise kann zum Beispiel gewährleistet werden, dass alle Tastschalter eines Bedienfeldes immer eine gleiche Empfindlichkeit aufweisen, einerseits zueinander und andererseits auch über einen langen Zeitraum hinweg. Es ist daher möglich, Temperatureinflüsse auf die optischen Sensoren der Tastschalter zu eliminieren, größere Toleranzen der Bauteile des optischen Sensors auszugleichen, die Tastschalter kontinuierlich abzugleichen, und dergleichen.

In einer vorteilhaften Ausgestaltung der Erfindung stellt die Auswerteschaltung in Abhängigkeit von dem erfassten Grundpegel des Auswertesignals einen zur Erkennung einer Betätigung des Tastschalters erforderlichen Mindesthub des Auswertesignals ein, zum Beispiel auf einen vorbestimmten Faktor eines dem erfassten Grundpegel entsprechenden Referenzhubes ein.

In einer weiteren Ausgestaltung der Erfindung weist die Referenzeinrichtung eine zumindest teildurchlässige Durchgangsöffnung einer Trennwand eines Blendenrahmens zwischen dem Sender und dem Empfänger auf, sodass unabhängig von einer Betätigung des Tastschalters immer ein Teil der von dem Sender ausgesendeten Strahlung direkt durch diese Durchgangsöffnung zum Empfänger gelangt.

In einer alternativen Ausgestaltung der Erfindung weist die Referenzeinrichtung die Abdeckung auf, die derart ausgebildet ist, dass ein Teil der von dem Sender ausgesendeten Strahlung an der vorderen und/oder der hinteren Oberfläche der Abdeckung in Richtung zum Empfänger reflektiert wird. Dies kann zum Beispiel durch die Wahl eines speziellen Brechungsindex des Materials der Abdeckung, durch eine spezielle Beschaffenheit der Oberflächen oder durch eine spezielle Beschichtung der Oberflächen der Abdeckung erreicht werden.

In einer weiteren alternativen Ausgestaltung der Erfindung weist die Referenzeinrichtung sowohl eine zumindest teildurchlässige Durchgangsöffnung einer Trennwand eines Blendenrahmens zwischen dem Sender und dem Empfänger als auch die Abdeckung, die einen Teil der von dem Sender ausgesendeten Strahlung an ihrer vorderen und/oder hinteren Oberfläche in Richtung zum Empfänger reflektiert, auf.

Obige sowie weitere Merkmale und Vorteile der Erfindung werden aus der nachfolgenden Beschreibung eines bevorzugten, nicht-einschränkenden Ausführungsbeispiels unter Bezugnahme auf die beiliegenden Zeichnungen besser verständlich. Darin zeigen:
- Fig. 1: eine Schnittansicht des Aufbaus eines berührungsempfindlichen Tastschalters gemäß einem bevorzugten Ausführungsbeispiel der vorliegenden Erfindung;
- Fig. 2: einen vereinfachten Schaltplan einer Auswerteschaltung für den berührungsempfindlichen Tastschalter von Fig. 1;
- Fig. 3: ein schematisches Signaldiagramm zur Erläuterung des Signalverlaufs eines Auswertesignals der Auswerteschaltung von Fig. 2; und
- Fig. 4: ein schematisches Signaldiagramm zur Erläuterung der Einstellung der Empfindlichkeit des optischen Sensors des berührungsempfindlichen Tastschalters von Fig. 1.

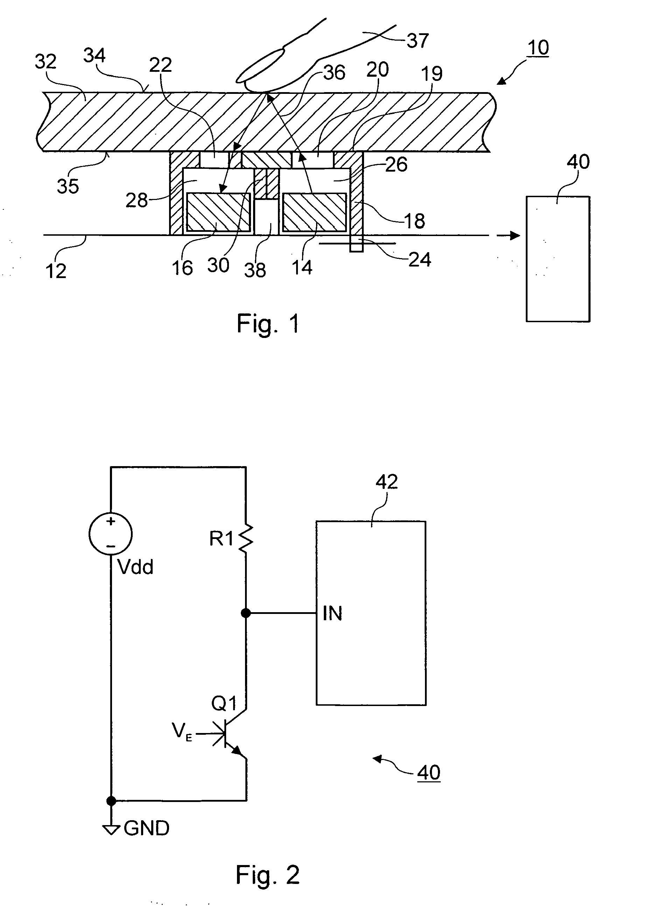

Anhand von Fig. 1 wird zunächst der mechanische Aufbau eines berührungsempfindlichen Tastschalters 10 der Erfindung näher erläutert. Der berührungsempfindliche Tastschalter der Erfindung ist zum Beispiel ein Infrarot-Tastschalter für ein Haushaltsgerät, wie einen Kochherd, einen Mikrowellenherd, ein Kochfeld, eine Waschmaschine, einen Wäschetrockner, eine Spülmaschine oder dergleichen, ohne dass die Erfindung auf eine elektromagnetische Strahlung dieses Wellenlängenbereichs oder diese spezielle Anwendungen beschränkt ist.

Der berührungsempfindliche Tastschalter 10 weist auf einer Leiterplatte 12 einen Infrarot-Sender 14 und einen Infrarot-Empfänger 16 auf. Der Sender 14 und der Empfänger 16 sind von einem Blendenrahmen 18 umgeben, der an seiner Oberseite 19 zwei Öffnungen 20 und 22 aufweist. Der aus einem IR-undurchlässigen Material gebildete Blendenrahmen 18 ist mit Füßen 24 durch Löcher in der Leiterplatte 12 eingesteckt und so an dieser befestigt.

Der Sender 14 und der Empfänger 16 sind so in dem Blendenrahmen 18 positioniert, dass sie innerhalb von jeweiligen Hohlräumen 26 und 28 unterhalb der Blendenöffnungen 20 und 22 angeordnet sind. Die beiden Hohlräume 26 und 28 sind dabei durch eine IR-undurchlässige Trennwand 30 voneinander getrennt. Direkt auf der Oberseite 19 des Blendenrahmens 18 liegt eine Abdeckung 32 aus einem für IR-Strahlung zumindest teildurchlässigen Material, zum Beispiel eine Glaskeramikplatte eines Haushaltskochherdes.

Die von dem Sender 14 ausgesendete Strahlung gelangt über einen optischen Weg 36 zur Oberseite 34 der Abdeckung 32. Bei einer Betätigung des berührungsempfindlichen Tastschalters 10 durch einen auf die Oberfläche der Abdeckung 32 gelegten Finger 37 wird die Strahlung des Senders 14 diffus und mehrfach gestreut, sodass genügend Streustrahlung auf den Empfänger 16 reflektiert wird und dieser ein entsprechendes Messsignal V_{E} an eine Auswerteschaltung 40 sendet, um eine entsprechende Schaltfunktion auszulösen.

Die Auswerteschaltung 40, die grundsätzlich einer Auswerteschaltung eines herkömmlichen Tastschalters entspricht, ist in Fig. 2 veranschaulicht. Das Messsignal V_{E} des Empfängers 16 schaltet einen ersten Transistor Q1 einer Spannungsteilerschaltung, die aus einem ersten Widerstand R1 und dem ersten Transistor Q1 aufgebaut ist und an die eine Versorgungsspannung Vdd angelegt ist. Das Auswertesignal V_{IN} wird zwischen dem ersten Widerstand R1 und dem ersten Transistor Q1 abgegriffen und einem Eingang IN eines Mikroprozessors 42 zur weiteren Verarbeitung zugeführt.

Im Fall eines funktionsfähigen Tastschalters 10 ist ohne Betätigung des Tastschalters 10 der erste Transistor Q1 hochohmig, sodass das Auswertesignal V_{IN} einen hohen Signalpegel besitzt. Bei einer Betätigung des Tastschalters 10 wird der erste Transistor 10 durch das Messsignal V_{E} des Empfängers 16 niederohmig geschaltet, sodass der Signalpegel des Auswertesignals V_{IN} entsprechend abfällt, was von dem Mikroprozessor 42 als eine Betätigung des Tastschalters 10 interpretiert wird.

Wieder Bezug nehmend auf Fig. 1 weist die Trennwand 30 des Blendenrahmens 18 eine Durchgangsöffnung 38 auf, die für die von dem Sender 14 ausgesendete elektromagnetische Strahlung zumindest teildurchlässig ist. Zusätzlich oder alternativ können die Oberseite 34 und/oder die Unterseite 35 der Abdeckung 32 so beschaffen oder beschichtet sein, dass zumindest ein Teil der elektromagnetischen Strahlung des Senders 14 in Richtung zum Empfänger 16 reflektiert wird. Auf diese Weise wird erreicht, dass der Empfänger 16 auch ohne eine Betätigung des Tastschalters 10 durch einen Benutzer eine gewisse Strahlungsmenge vom Sender 14 empfängt und ein entsprechendes Messsignal V_{E} für die Auswerteschaltung 40 erzeugt.

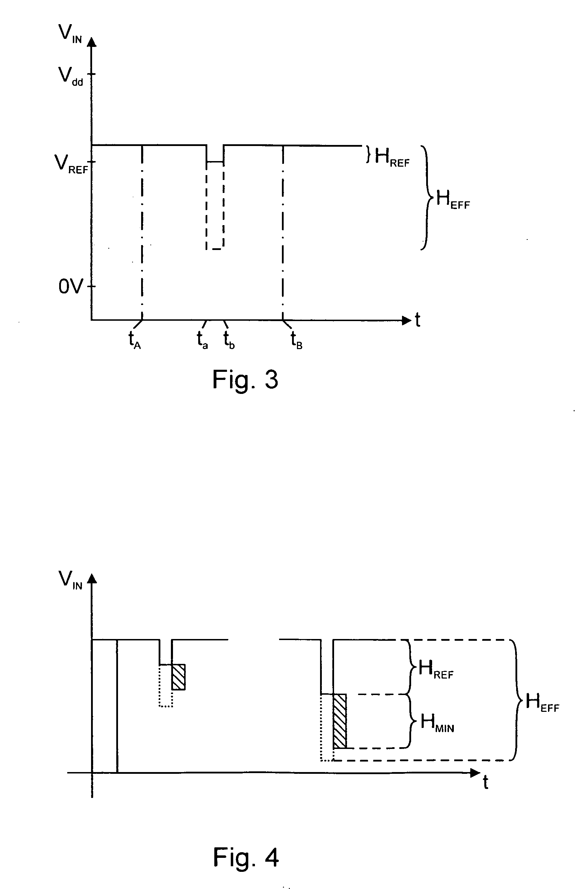

Unter Bezugnahme auf Fig. 3 wird nun zunächst der Signalverlauf eines Auswertesignals V_{IN} des erfindungsgemäßen Tastschalters 10 beschrieben.

Wie in Fig. 3 dargestellt, wird der Tastschalter 10 im Multiplexbetrieb im Zeitfenster t_{A} bis t_{B} ausgewertet. Innerhalb dieses Zeitfensters t_{A} - t_{B} existiert ein Sendetakt tₐ bis t_{b}, in dem der Sender 14 Strahlung aussendet. Außerhalb des Zeitfensters t_{A} - t_{B} ist der Multiplexbetrieb auf andere Tastschalter des Bedienfeldes geschaltet.

Fig. 3 zeigt in durchgezogener Linie den Signalverlauf eines Auswertesignals V_{IN} ohne Betätigung des Tastschalters 10 (und ohne Überstrahlung des Tastschalters 10). Als Reaktion auf die vom Sender 14 ausgesendete Strahlung erzeugt der Empfänger 16 ein Messsignal V_{E}, das auch ohne Betätigung des Tastschalters 10 während des Sendetakts tₐ - t_{b} zu einer leichten Erniedrigung (um einen Referenzhub H_{REF}) des Auswertesignalpegels V_{IN} auf einen Grundpegel V_{REF} führt. Dieser Grundpegel V_{REF} ist zum Beispiel durch eine definierte Schlitzbreite der Durchgangsöffnung 38 oder über ein Reflexionsvermögen der Oberseite 34 der Abdeckung 32 definiert.

Diese Erniedrigung des Auswertesignals V_{IN} ist im Fall einer Tastschalterbetätigung deutlich stärker ausgeprägt, wie durch einen gestrichelten Signalverlauf in Fig. 3 angedeutet. Der Signalhub H_{EFF} ist signifikant größer als der Referenzhub H_{REF}.

Wie in Fig. 4 veranschaulicht, hängt der Signalhub H_{EFF} im Allgemeinen proportional von der aktuellen Empfindlichkeit des Tastschalters 10 ab. Im Fall eines schwachen Tastschalters 10 (links in Fig. 4) ist der Signalhub H_{EFF} bei einer Betätigung des Tastschalters 10 entsprechend kleiner als bei einem starken / empfindlichen Tastschalter 10 (rechts in Fig. 4). Dieses Verhalten gilt gleichermaßen für den Referenzhub H_{REF} des Auswertesignals V_{IN}, was gemäß der Erfindung wie folgt ausgenutzt wird.

Damit der Mikroprozessor 42 die Betätigung des Tastschalters 10 erkennt, muss der Signalhub H_{EFF} des Auswertesignals V_{IN} während des Sendetakts tₐ- t_{b} des Senders 14 des optischen Sensors einen bestimmten Mindesthub H_{MIN} übersteigen. Während dieser Mindesthub H_{MIN} bei einem herkömmlichen Tastschalter fest vorgegeben ist, wird im Fall der vorliegenden Erfindung dieser Mindesthub H_{MIN} jeweils aktuell angepasst, wie in Fig. 4 dargestellt.

Insbesondere wird der zur Erkennung einer Tastschalterbetätigung erforderliche Mindesthub H_{MIN} in Abhängigkeit von dem erfindungsgemäß erfassten Grundpegel V_{REF} des Auswertesignals V_{IN} eingestellt. In einem Ausführungsbeispiel kann der Mindesthub H_{MIN} auf einen bestimmten Faktor (z.B. etwa Faktor 2 in Fig. 4) des dem Grundpegel V_{REF} entsprechenden Referenzhubes H_{REF} eingestellt werden. Wie in Fig. 4 erkennbar, muss damit im Fall eines empfindlicheren Tastschalters 10 ein größerer Signalhub H_{EFF} erfasst werden, damit der Mikroprozessor 42 auf eine Betätigung des Tastschalters 10 erkennt, als bei einem unempfindlicheren Tastschalter 10, d.h. aufgrund der angepassten Schwelle H_{MIN} zur Tastenerkennung reagieren die beiden Tastschalter 10 trotz tatsächlich unterschiedlicher Eigenschaften gleich.

Durch eine derartige Einstellung der Empfindlichkeit des optischen Sensors, genauer des zur Erkennung einer Tastschalterbetätigung benötigten Mindesthubes H_{MIN'} mittels Software im Mikroprozessor 42 kann auf einfache und zuverlässige Weise erzielt werden, dass in einem Bedienfeld alle Tastschalter für einen Benutzer gleich reagieren, was die Bedienbarkeit vereinfacht. Außerdem können Temperatureinflüsse und Empfindlichkeitstoleranzen bzw. Toleranzfehler des optischen Sensors beseitigt oder zumindest minimiert werden, da der Tastschalter fortlaufend auf ein gutes Tastenverhalten nachjustiert wird.

Während die Erfindung oben anhand eines bevorzugten Ausführungsbeispiels unter Bezugnahme auf die beiliegenden Zeichnungen beschrieben worden ist, ist es für den Fachmann selbstverständlich, dass auch weitere Varianten und Modifikationen daran vorgenommen werden können, ohne den durch die anhängenden Ansprüche definierten Schutzumfang der Erfindung zu verlassen.

Zum Beispiel können in den gezeigten Diagrammen der Fig. 2 bis 4 die Polaritäten vertauscht werden, ohne dass dies die Wirkungen und Vorteile der Erfindung beeinträchtigen würde.

### BEZUGSZIFFERNLISTE

- 10: Tastschalter
- 12: Leiterplatte
- 14: Sender
- 16: Empfänger
- 18: Blendenrahmen
- 1 9: Oberseite des Blendenrahmens
- 20: Blendenöffnung
- 22: Blendenöffnung
- 24: Fuß des Blendenrahmens
- 26: Hohlraum
- 28: Hohlraum
- 30: Trennwand
- 32: Abdeckung
- 34: Oberseite der Abdeckung
- 35: Unterseite der Abdeckung
- 36: optischer Weg
- 37: Finger eines Benutzers
- 38: Durchgangsöffnung
- 40: Auswerteschaltung
- 42: Mikroprozessor

## Patentansprüche

1. Berührungsempfindlicher Tastschalter (10), mit
einem optischen Sensor, der einen elektromagnetische Strahlung aussendenden Sender (14) und einen elektromagnetische Strahlung empfangenden Empfänger (16) enthält und der hinter einer für die elektromagnetische Strahlung zumindest teildurchlässigen Abdeckung (32) angeordnet ist; und
einer Auswerteschaltung (40) zum Auswerten eines von dem Empfänger (16) des optischen Sensors erzeugten Messsignals (V_{E}) und Erzeugen eines Auswertesignals (V_{IN}),
**dadurch gekennzeichnet,**
**dass** ferner eine Referenzeinrichtung (32, 38) zum Leiten eines Teils der von dem Sender (14) ausgesendeten elektromagnetischen Strahlung auch ohne Betätigung des Tastschalters (10) zum Empfänger (16) und Erzeugen eines Grundpegel (V_{REF}) des Auswertesignals (V_{IN}) vorgesehen ist; und
**dass** die Auswerteschaltung (40) in Abhängigkeit von dem erfassten Grundpegel (V_{REF}) des Auswertesignals (V_{IN}) eine Empfindlichkeit des optischen Sensors einstellt.

2. Tastschalter nach Anspruch 1,
**dadurch gekennzeichnet,**
**dass** die Auswerteschaltung (40) in Abhängigkeit von dem erfassten Grundpegel (V_{REF}) des Auswertesignals (V_{IN}) einen zur Erkennung einer Betätigung des Tastschalters (10) erforderlichen Mindesthub (H_{MIN}) des Auswertesignals (V_{IN}) einstellt.

3. Tastschalter nach Anspruch 2,
**dadurch gekennzeichnet,**
**dass** der zur Erkennung einer Betätigung des Tastschalters (10) erforderliche Mindesthub (H_{MIN}) des Auswertesignals (V_{IN}) auf einen vorbestimmten Faktor eines dem erfassten Grundpegel (V_{REF}) entsprechenden Referenzhubes (H_{REF}) eingestellt wird.

4. Tastschalter nach einem der Ansprüche 1 bis 3,
**dadurch gekennzeichnet,**
**dass** die Referenzeinrichtung eine zumindest teildurchlässige Durchgangsöffnung (38) einer Trennwand (30) eines Blendenrahmens (18) zwischen dem Sender (14) und dem Empfänger (16) aufweist.

5. Tastschalter nach einem der Ansprüche 1 bis 3,
**dadurch gekennzeichnet,**
**dass** die Referenzeinrichtung die Abdeckung (32) aufweist, die derart ausgebildet ist, dass ein Teil der von dem Sender (14) ausgesendeten Strahlung an der vorderen und/oder der hinteren Oberfläche (34, 35) der Abdeckung in Richtung zum Empfänger (16) reflektiert wird.

6. Tastschalter nach einem der Ansprüche 1 bis 3,
**dadurch gekennzeichnet,**
**dass** die Referenzeinrichtung eine zumindest teildurchlässige Durchgangsöffnung (38) einer Trennwand (30) eines Blendenrahmens (18) zwischen dem Sender (14) und dem Empfänger (16) sowie die Abdeckung (32), die derart ausgebildet ist, dass ein Teil der von dem Sender (14) ausgesendeten Strahlung an der vorderen und/oder der hinteren Oberfläche (34, 35) der Abdeckung in Richtung zum Empfänger (16) reflektiert wird, aufweist.

7. Tastschalter nach einem der vorherigen Ansprüche,
**dadurch gekennzeichnet,**
**dass** die elektromagnetische Strahlung Infrarot-Strahlung ist.
